# FASCICULE DE BREVET EUROPEEN

(11) **EP 3 715 872 B1**
(45) Date de publication et mention de la délivrance du brevet: **27.10.2021**
(21) Numéro de dépôt: 20162992.0
(22) Date de dépôt: 13.03.2020
(51) Int. Cl.: G01R 19/00, G01R 27/00, G01R 31/08, B23B 51/08, H02G 1/08, H01R 11/28, G01R 31/58, B23B 51/00

(54) **DISPOSITIF D'INJECTION DE COURANT DANS UN CONDUCTEUR CÂBLÉ ET PROCÉDÉ D'INJECTION DE COURANT DANS UN CONDUCTEUR CÂBLÉ**
VORRICHTUNG ZUR STROMINJEKTION IN EINEN LITZENLEITER UND VERFAHREN ZUR STROMINJEKTION IN EINEN LITZENLEITER
DEVICE FOR INJECTING CURRENT INTO A WIRED CONDUCTOR AND METHOD FOR INJECTING CURRENT INTO A WIRED CONDUCTOR

(30) Priorité: 25.03.2019 CH 3802019
(43) Date de publication de la demande: 30.09.2020
(73) Titulaire: AESA SA, 2022 Bevaix (CH)
(72) Inventeur: Dardel, Boris, 2035 Corcelles (CH); De Bruyne, Patrick, 1308 La Chaux (CH); Arbet-Engels, Vincent, 1232 Confignon (CH)
(74) Mandataire: P&TS SA (AG, Ltd.)

(56) Documents cités:
- EP-A1- 0 168 346
- CH-A1- 709 473
- ES-U- 1 086 830
- GB-A- 2 473 068
- US-A1- 2007 201 963
- US-A1- 2012 256 144
- US-A1- 2015 137 802

## Description

### Domaine technique

La présente invention concerne un dispositif et un procédé pour l'injection d'un courant dans un câble électrique. En outre, le dispositif comprend des moyens pour mesurer la résistance linéique d'un câble électrique de longueur déterminée.

### Etat de la technique

Les lignes de transmission d'énergie électrique à haute tension sont couramment équipées des câbles multiconducteurs en aluminium. La connexion électrique de ces câbles présente des complications spéciales, car les conducteurs individuels qui composent le câble sont isolés électriquement entre eux par une couche d'oxyde. Une distribution uniforme de courant dans le câble est difficile à obtenir, même par des forces de serrage élevées.

Ces difficultés sont exacerbées lorsqu'on travaille avec des câbles qui présentent des barrières isolantes introduites à dessein entre les conducteurs pour la réduction de l'effet peau. C'est notamment le cas des câbles "Milliken", des conducteurs étanches, et des câbles à conducteurs émaillés. Dans ces produits, les conducteurs sont groupés en secteurs isolés par l'interposition de couches de ruban isolant, et/ou enrobés d'émail isolant.

On connait plusieurs sortes de dispositifs pour connecter un câble multiconducteurs à un circuit de n'importe quelle nature, par exemple des brides métalliques, avec ou sans vis de contact, des manchons sertis, des embouts soudés, etc.

La problématique de ces connexions réside essentiellement dans leur capacité à injecter le courant dans le câble de façon à obtenir une distribution de courant homogène dans la section transversale du conducteur avec un effort de mise en oeuvre réduit. La présente invention répond à ce besoin.

L'invention peut être utilisée avantageusement en lieu des dispositifs cités précédemment dans un grand nombre d'applications.

Il est notamment fréquemment nécessaire de mesurer la résistance ohmique de câbles électriques conducteurs, par exemple lors de leur conception et lors de leur fabrication. Les mesures sont par exemple effectuées sur une longueur de câble précise, en général un mètre, au moyen d'une mesure de type Kelvin, aussi connue sous le nom de "mesure à quatre fils", dans laquelle l'on injecte dans le câble un courant électrique précisément connu, et l'on mesure la différence de tension entre deux points écartés le long du câble. La précision de la mesure dépend de nombreux facteurs, y compris la distance précise entre les deux points de contact électrique, la température, la précision de l'ohmmètre, la distribution du courant dans la section transversale du câble, etc. La présente invention vise en particulier à améliorer l'injection de courant dans le câble et par conséquent sa distribution dans la section transversale qui a une influence directe sur l'exactitude de la mesure.

La norme chinoise GBT3048.4-2007, relative à la mesure de la résistance en courant continu des câbles électriques, mentionne notamment que pour les conducteurs de classe 2 (multibrins) tous les fils doivent être bien connectés aux connecteurs d'injection de courant, ce qui n'est le cas que su chacun des fils a un contact direct avec le connecteur.

CH709473 décrit un dispositif automatique permettant la mesure de la résistance linéique de câbles. Ces appareils sont utilisés dans les usines de production, entre autres, pour le contrôle des caractéristiques électriques des câbles fabriqués.

Dans les dispositifs susmentionnés, l'injection de courant est réalisée par des moyens de serrage entre lesquels on referme une section de câble dont on souhaite mesurer la résistivité. La force de serrage requise pour obtenir un contact électrique d'excellente qualité est considérable, particulièrement lorsqu'on souhaite mesurer des câbles de calibre important. Les appareils destinés à la caractérisation des câbles à haute tension utilisent normalement des mors à actionnement hydraulique capables d'exercer une force de compression de plusieurs tonnes.

L'invention permet de réduire (voir supprimer) les forces de compression nécessaires à la connexion, tout en améliorant l'homogénéité du courant au sein de la section transversale.

### Bref résumé de l'invention

Un objet de la présente invention est de proposer un dispositif pour la connexion électrique avec un câble électrique qui permet d'obtenir une distribution de courant plus uniforme que les dispositifs de la technique connue, et un procédé pour l'injection d'un courant électrique dans un câble électrique. En outre, le dispositif comprend des moyens pour la mesure de la résistance linéique du câble sous connexion.

Selon l'invention, ces buts sont atteints notamment au moyen d'un dispositif, selon la revendication 1, pour l'injection d'un courant dans un câble électrique comprenant un dispositif de serrage arrangé pour serrer et maintenir le câble électrique et exercer une pression sur une surface latérale du câble électrique en proximité d'une face du câble, un outil d'usinage, des moyens d'entraînement et/ou guidage de l'outil d'usinage, arrangés de façon à percer une cavité axiale dans la face du câble vers l'intérieur, un circuit électrique relié à un objet conducteur inséré dans la cavité axiale pour l'injection du courant électrique dans le câble.

Des variantes avantageuses de l'invention sont l'objet des revendications dépendantes 2-7 et portent entre autres sur le fait que la face est essentiellement orthogonale à un axe longitudinal du câble et sur la sélection d'une fraise conique ou étagée pour l'outil d'usinage.

Lorsque l'injection est dans un câble multiconducteurs, il est avantageux de poursuivre l'enfoncement de l'outil conique jusqu'à ce qu'il atteigne les conducteurs de la couronne la plus externe. Dans une application préférée, le dispositif d'injection de courant de l'invention est dupliqué, pour faire circuler un courant prédéterminé dans un brin de câble serré entre deux mors et percé axialement par deux fraises; deux contacts sont posés sur le câble pour mesurer la différence de potentiel électrique à deux points séparés d'une distance connue, et un circuit logique opportunément programmé calcule la résistance linéique, préférablement avec compensation de la température.

L'objet conducteur peut être le même outil d'usinage ou bien un insert conducteur dont la forme épouse celle de la cavité. L'insert conducteur peut présenter un filetage pour être vissé dans la cavité, soudé par friction dans la cavité, maintenu en contact par pression ou par tout moyen idoine.

Lorsque l'outil d'usinage a aussi la fonction d'objet conducteur, on peut choisir les paramètres de perçage pour le faire bloquer dans la cavité axiale afin d'obtenir un meilleur contact électrique.

L'invention porte aussi sur les procédés qui sont l'objet des revendications 8-14 correspondantes.

### Brève description des figures

Des exemples de mise en oeuvre de l'invention sont indiqués dans la description illustrée par les figures annexées dans lesquelles :
- La figure 1 illustre - de manière fortement simplifiée - un dispositif de mesure de la résistance linéique d'un câble de type connu.
- La figure 2 montre une fraise conique en train de percer axialement un câble serré dans un collier de serrage
- La figure 3 montre la fraise grippée dans le perçage effectué sur le câble, et le circuit d'injection du courant passant par la fraise.
- La figure 4 montre un insert conducteur inséré dans la cavité axiale réalisé précédemment dans le câble. L'insert comporte un filetage pour le visser dans la cavité et réaliser de cette façon un contact optimal avec tous les brins conducteurs du câble.

### Exemple(s) de mode de réalisation de l'invention

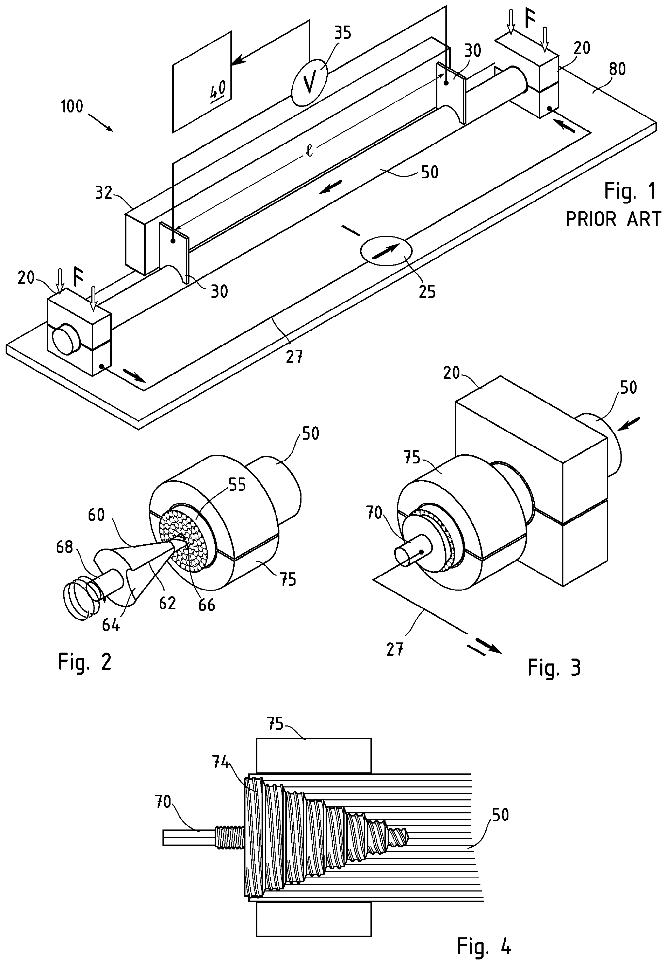

Un mode de réalisation de l'invention sera maintenant décrit avec référence aux figures. Bien que l'invention admette d'autres applications (connectique des câbles), un cas d'usage important est celui des appareils pour la mesure de la résistance linéique des câbles électriques, dont la figure 1 montre un schéma conceptuel simplifié. Pour une description plus détaillée, le lecteur peut se référer au brevet suisse cité plus haut.

Le dispositif de mesure 100 comporte, sur un bâti 80, deux mors 20 destinés à serrer une section de conducteur câblé 50. Le conducteur 50 est maintenu en suspension entre les deux mors 50 et l'écartement entre les mors est supérieur à la longueur normalisée ℓ de conducteur dont on souhaite mesurer la résistance. Dans un mode de réalisation typique, la longueur ℓ est égale à un mètre et les mors sont espacés de 120 à 150 cm, pouvant atteindre et dépasser 350 cm pour des câbles de grande section. Le choix de la distance entre les mors est lié à la précision de mesure qu'on recherche, à l'homogénéité de la répartition de courant dans les conducteurs, au diamètre du câble, au nombre et à la disposition des conducteurs individuels. Un avantage de l'invention réside précisément dans le fait qu'une meilleure répartition de courant permet de réduire la distance entre les mors sans sacrifier la précision, et donc de limiter la taille du dispositif de mesure.

Toujours dans un mode de réalisation typique, on peut concevoir que le conducteur 50 soit une section d'un câble multibrin en Aluminium avec une section entre 100 mm² et 4'000 mm², mais cela n'est pas une caractéristique essentielle de l'invention qui peut être appliquée aussi à des câbles de section plus grande, ou plus petite.

La flexibilité des câbles de forte section est négligeable par rapport à l'échelle du dispositif. Il est possible d'ajouter des supports isolants pour soutenir le câble entre les deux mors, lorsqu'on mesure des câbles plus fins et flexibles. Un des mors peut être monté sur une coulisse alignée avec l'axe longitudinal du câble 50, pour mettre ce dernier en tension lors de la mesure.

Dans les machines de type connu, les mors 20 sont reliés par un circuit 27 à une source de courant 25, ce qui détermine la circulation d'un courant connu dans le conducteur 50. Les mors 20 sont fortement serrés, par exemple par des actionneurs hydrauliques, dans le but de réaliser un contact intime entre les brins individuels du câble conducteur 50 et permettre l'établissement d'un profil de courant à l'intérieur du câble le plus possible identique à ce qu'on observe dans une ligne de transmission d'énergie. Si le câble 50 est isolé par une couche diélectrique, les segments terminaux devront être dénués avant leur introduction dans les mors 20.

La mesure de la résistance linéique est généralement une mesure en courant continu, comme requis par la plupart des normes en vigueur. L'invention s'applique également aux mesures en AC, dans lesquelles la fréquence du courant d'excitation généré par la source 25 est choisie sensiblement identique à celle que le conducteur est destiné à transmettre, soit par exemple 50 Hz ou 60 Hz.

Le dispositif de mesure 100 comporte une règle 32 portant des couteaux conducteurs 30 destinés à entrer en contact avec le câble 50 et mesurer la différence de potentiel électrique entre deux points sur le câble, dont l'écartement ℓ est exactement déterminé par les dimensions de la règle 32. Un voltmètre 35 mesure la différence de potentiel V entre les deux couteaux.

On comprend que la résistance linéique du câble peut être déterminée à partir de la connaissance du courant circulant I, de la différence de potentiel V, de la longueur ℓ. Le dispositif de mesure comporte un circuit logique 40 programmé pour déterminer, afficher et/ou enregistrer automatiquement la résistance linéique du câble se basant sur les quantités I, V, ℓ. Préférablement, le circuit logique 40 reçoit aussi un signal de température fourni par un capteur (non visible sur les figures) sensible à la température du câble et applique les corrections requises pour fournir la résistance normalisée à une température standard, par exemple 20 °C.

Les dispositifs de l'art antérieur avec injection de courant par les mors 20 se caractérisent par la praticité d'usage, car la seule opération de serrer le câble dans les mors 20 fixe le câble dans l'instrument et en même temps réalise le contact électrique pour l'injection du courant d'excitation. Comme on a vu dans l'introduction, cette solution ne permet pas d'approximer exactement une distribution idéale de courant à l'intérieur des câbles en aluminium, en raison des couches d'oxyde naturellement présentes sur les brins, dont l'effet ne peut pas être complètement annulé par la pression des mors. Ces inconvénients sont plus sérieux lorsqu'on doit mesurer des câbles comportant des secteurs isolés, ou des brins émaillés, tels que les câbles "Milliken" et les câbles étanches. L'invention propose, dans une machine ayant la structure générale illustrée sur la figure 1, un système d'injection de courant plus efficace qui sera maintenant illustré avec référence aux figures 2 et 3.

La figure 2 illustre un conducteur 50 serré dans un collier de serrage 75. Le conducteur 50 se compose d'une pluralité de brins individuels torsadés, par exemple en aluminium, qui peuvent être totalement ou partiellement isolés les uns par rapport aux brins adjacents par une couche d'oxyde naturelle ou bien par des barrières diélectriques interposées à dessein, par exemple des rubans isolants ou des couches d'émail. Le conducteur 50 est coupé en proximité du collier 75 de façon à présenter une face transversale 55 en proximité du collier 75.

Un outil de coupe 60 est amené en contact avec la face libre 55 et guidé pour percer le câble 50 le long de son axe longitudinal. Préférablement l'outil de coupe 60 présente un diamètre croissant en allant de la pointe 66 vers la queue 68 et son diamètre maximal est choisi en fonction des dimensions du câble 50, de façon à atteindre, lorsque l'outil est suffisamment enfoncé, les brins le plus externes du câble 50.

Des essais sur des câbles multibrins en aluminium ont donné des résultats très positifs. Dans ces tests, les outils 60 étaient constitués par des forets coniques ou à étages, du type couramment employé pour percer des tôles métalliques. Le perçage peut être effectué manuellement, avec une perceuse électroportative ou automatiquement, par une broche porte-outils automatique intégrée au dispositif 100 ou, préférablement, sur un dispositif distinct pour éviter la dissémination de copeaux.

Il est connu que, dans toute opération de coupe par outils, les paramètres opérationnels de l'outil (vitesse de coupe, avancement, force) déterminent directement la qualité du perçage et qu'un choix de paramètres trop agressifs peut conduire au blocage de l'outil dans la pièce usinée. Contrairement à la pratique courante, le perçage du conducteur a lieu en deux étapes :
a. dans une première phase d'avancement les paramètres opérationnels de l'outil sont choisis pour favoriser l'évacuation de copeaux et l'avancement régulier de l'outil.
b. Dans une seconde phase de blocage, les paramètres opérationnels de l'outil sont choisis de façon à faire gripper l'outil d'usinage dans le perçage.

L'avantage de ce procédé est que l'outil de coupe est en contact intime avec les brins conducteurs et que l'interface n'est jamais en contact avec l'oxygène atmosphérique, donc le contact électrique entre l'outil et les conducteurs composant le câble est optimal.

L'homme du métier sait déterminer, en connaissant les caractéristiques du câble et du foret employés les paramètres à utiliser dans l'une et dans l'autre phase. Préférablement, dans la phase d'avancement, on alterne des mouvements d'avancement et de retrait de l'outil, afin de favoriser l'évacuation des copeaux. Un avant-trou percé avec un foret cylindrique de petit diamètre peut aussi être utile pour le guidage. Le moteur utilisé pour l'entraînement de l'outil rotatif inclut préférablement un limiteur de couple, et arrête automatiquement son action lorsque l'outil se bloque.

Dans une variante de réalisation de l'invention, la préparation du contact comporte une première phase d'avancement de l'outil de coupe 60, dans laquelle les paramètres opérationnels de l'outil sont choisis pour favoriser l'évacuation de copeaux et l'avancement régulier de l'outil 60 suivie par le retrait de l'outil et l'insertion d'un insert conducteur 70 dont la forme épouse la cavité laissée par l'outil. L'avantage de cette procédure est que l'insert conducteur 70, contrairement à l'outil 60 ne présente pas de canal pour l'évacuation des copeaux et touche en mesure égale tous les conducteurs composant le câble 50.

Après le blocage, l'outil 60 est relié au circuit d'excitation 27 et l'introduction du courant se fait à travers l'outil 60 (qui est un bon conducteur d'électricité), ou bien par l'insert conducteur 70. La figure 3 illustre comme le câble 50 avec le dispositif d'injection de courant de l'invention peut être inséré dans une machine de mesure de la résistance linéique comme celle de la figure 1. Les mors 20 maintiennent leur fonction de support mécanique et sont utilisés pour mettre le câble en tension, mais l'injection de courant est faite principalement par l'insert conducteur 70. Cela n'empêche toutefois l'utilisation du mors 20 pour améliorer le contact électrique en parallèle à l'outil 60.

Dans une variante possible, l'insert 70 présente un filetage, ou plusieurs filetages 74, destinés à s'engager dans le matériau conducteur du câble 50, comme il est visible sur la figure 4. Avantageusement, la liaison vissée permet une bonne fixation mécanique et améliore le contact électrique car les tranchants de filetages brisent la couche externe des conducteurs, qui peuvent s'être oxydés entre le fraisage et l'insertion de l'insert 70.

L'insert fileté 70 visible sur la figure 4 est préférablement réalisé en acier, en laiton, ou en un matériau plus dur que celui du câble 50 (typiquement aluminium ou cuivre), et peut avoir subi des traitements, par exemple la déposition de couches anti-usure, pour améliorer sa durabilité. Avantageusement, l'insert fileté peut être dévissé et utilisé pour plusieurs opérations de contact. Le câbles en aluminium peuvent avantageusement être fileté et mesuré avec un insert 70 en laiton, car la dureté de ce matériau s'est avéré suffisante pour créer un filetage satisfaisant dans l'aluminium. Pour les conducteurs en cuivre, on peut utiliser un insert fileté en un alliage cuivreux durcissable, ou bien former le filetage intérieur à l'aide d'un outil en acier avant d'insérer un insert 70 en laiton.

Dans une autre variante non illustrée, l'insert 70 est connecté à une broche électrique ou à un autre moyen d'entraînement qui le mette en mouvement, et pressé à l'intérieur du perçage. La vitesse de l'insert et la pression sont choisies de façon à générer un échauffement par friction suffisant à souder l'insert 70 dans la cavité axiale laissée par le perçage.

Le matériau de l'insert 70 doit, en cette application, être de nature à pouvoir se souder facilement avec le métal conducteur du câble. On utilise typiquement pour l'insert le même métal (aluminium ou cuivre) que le câble 50. Si cette solution peut conduire à un contact excellent, les forces de contact sont importantes et demandent un système mécanique plus robuste. La liaison entre l'insert et le câble est permanente : chaque connexion requiert un nouvel insert.

Idéalement, le système d'injection de courant de l'invention vise à réaliser une liaison avec tous les conducteurs individuels du câble avec une résistance (ou une impédance dans le cas de mesure en AC) aussi petite et constante que possible vers chaque conducteur, pour avoir une répartition entre les conducteurs fidèle à celle du câble en service. Des essais fait avec des forets coniques ou à étage du commerce ont déjà permis d'approcher ce résultat idéal mieux que les systèmes d'injection de courant connus.

Il est possible simuler dans quelle mesure la forme de l'outil choisi détermine les surfaces de contact avec les conducteurs individuels, et choisir pour chaque câble une forme de fraise "sur mesure", par exemple en variant la taille et le nombre des étages, qui réalise des contacts de surface le plus possible identique avec brin du câble.

Une fonction importante des colliers de serrage 75 dans la présente invention est de contraster l'ouverture du câble lors de l'avancement de l'outil. De ce fait, l'invention admet aussi avec des moyens de serrages différents des mors hydrauliques employés dans les appareils connus. On pourrait par exemple remplacer ou aider les mors 75 par des colliers flexibles tendus autour du conducteur, par des rubans adhésifs ayant une résistance mécanique appropriée (des essais avec des rubans adhésifs renforcés par des fibres de verre ont donné des résultats concluants) ou par tout autre moyen de serrage approprié.

Le perçage peut être effectué à sec ou avec un lubrifiant. Préférablement on choisira un lubrifiant qui ne laisse pas une couche d'huile isolante sur les surfaces, par exemple eau ou alcool.

### Exemple 1 : conducteur câblé de 240 mm²

La résistance linéique d'un câble conducteur en aluminium de 240 mm² de section a été mesurée avec le procédé usuel (injection de courant par les mors) et avec le procédé de l'invention, sur le même dispositif de mesure.

On a employé des forets à étages dont le diamètre va de 4 à 20 mm. Lors de la mesure avec le procédé de l'invention, le câble 50 était isolé du mors 20 par une couche diélectrique. Les perçages ont été effectués à sec.

La valeur attendue pour la résistance linéique est de 125.2 µΩ/m. Chaque mesure a été répétée dix fois en changeant la position du conducteur pour déterminer une valeur moyenne et son écart type. Les résultats sont présentés dans le tableau 1.

**Table 1 : câble de 240 mm²**

| connexion | serrage mors bar | tension nm | résistance µΩ/m | écart type |
|---|---|---|---|---|
| mors | 350 | 20 | 127.20 | 0.62 % |
| foret à étages | 200 | 20 | 125.44 | 0.28 % |

On constate que le procédé de l'invention donne un résultat plus proche de la valeur attendue, avec un moindre écart type que le procédé usuel, malgré un serrage plus léger.

### Exemple 2 : conducteur câblé de 300 mm² étanche

Un câble étanche de 300 mm² de section a été mesuré comme pour l'exemple 1. Le câble comporte un ruban gonflant non conducteur placé longitudinalement à recouvrement entre chaque couche de conducteurs individuels. Par comparaison, on a inclus une mesure sur un câble de caractéristiques électriques identiques, mais non étanche, donc sans ruban gonflant.

Lorsqu'on utilise la méthode de l'invention, les mors ne sont pas isolés du câble, mais ceux-ci ne sont pas alimentés en courant.

La valeur de résistance linéique attendue pour ces conducteurs est de 100 µΩ/m.

**Table 2 : câble de 300 mm²**

| câble | connexion | serrage bar | tension nm | résistance µΩ/m | écart type % |
|---|---|---|---|---|---|
| standard | mors | 200 | 200 | 99.75 | 0.15 |
| étanche | mors | 300 | 200 | 107.65 | 0.51 |
| étanche | foret | 300 | 200 | 100.95 | 0.17 |

On constate aussi les avantages de la méthode de l'invention.

### Exemple 3 : conducteur câblé de 1'000 mm² étanche

Un câble étanche de 1000 mm² de section a été mesuré comme pour l'exemple 2. La valeur de résistance attendue est de 29.1 µΩ/m.

**Table 3 : câble de 1'000 mm²**

| câble | connexion | serrage bar | tension nm | résistance µΩ/m | écart type % |
|---|---|---|---|---|---|
| étanche | mors | 300 | 200 | 25.58 | 5.2 |
| étanche | foret | 300 | 200 | 28.62 | 0.47 |

Ce câble serait difficilement mesurable sans recourir à l'invention, en raison de l'écart type important.

### Numéros de référence employés sur les figures

- 20: mors
- 25: source de courant
- 27: conducteur pour l'injection du courant de mesure
- 30: couteau
- 32: règle
- 35: mesure de tension
- 40: circuit logique
- 50: câble
- 55: face
- 60: outil de coupe
- 62: tranchant
- 64: dégagement
- 66: pointe de l'outil
- 68: queue de l'outil
- 70: insert conducteur
- 74: filetage
- 75: collier de serrage
- 80: châssis
- 100: dispositif de mesure

## Revendications

1. Dispositif pour l'injection d'un courant (I) dans un câble électrique (50) comprenant un dispositif de serrage (75) arrangé pour serrer et maintenir le câble électrique (50) et exercer une pression sur une surface latérale du câble électrique (50) en proximité d'une face (55) du câble, un outil d'usinage (60), des moyens d'entraînement et/ou guidage de l'outil d'usinage (60) arrangés de façon à percer une cavité axiale dans la face (55) du câble (50) vers l'intérieur, un circuit électrique (27) relié à un objet conducteur (60, 70) inséré dans la cavité axiale pour l'injection du courant électrique dans le câble.

2. Dispositif selon la revendication précédente, dans lequel l'objet conducteur est l'outil d'usinage (60) utilisé pour le perçage de la cavité axiale, ou bien un insert conducteur (70) dont la forme épouse celle de la cavité axiale.

3. Dispositif selon l'une des revendications précédentes, dans lequel l'outil d'usinage (60) est une fraise conique ou étagée.

4. Dispositif selon l'une des revendications précédentes, dans lequel l'opération de perçage comprend :
- une phase d'avancement dans laquelle les paramètres opérationnels de l'outil sont choisis pour favoriser l'évacuation de copeaux
- une phase de blocage dans laquelle les paramètres opérationnels de l'outil sont choisis de façon à faire gripper l'outil d'usinage dans le perçage.

5. Dispositif selon l'une des revendications précédentes dans lequel l'objet conducteur (70) présente un filetage (74) pour le visser dans la cavité axiale, ou bien le dispositif comprend des moyens pour entraîner en mouvement l'objet conducteur (70) à l'intérieur de la cavité axiale et le presser contre les parois de la cavité axiale pour générer une friction et souder l'objet conducteur (70) dans la cavité axiale.

6. Dispositif selon l'une des revendications précédentes comprenant en outre deux contacts (50) séparés d'une distance connue (ℓ) en contact électrique avec le câble parcouru par le courant électrique, un dispositif de mesure de la tension électrique (35) entre les deux contacts (30) et un circuit logique arrangé pour déterminer la résistance linéique du câble (50) se basant sur la valeur du courant circulant dans le câble, de la tension électrique entre les deux contacts (30), et de la distance connue séparant les contacts électriques (30).

7. Dispositif de la revendication précédente, comprenant en outre un capteur de température pour déterminer la température du câble, le circuit logique étant arrangé pour corriger la résistance linéique se basant sur la température du câble.

8. Procédé pour l'injection d'un courant électrique (I) dans un câble électrique (50) comprenant les opérations de :
- obtenir une face (55) correspondante à une section transversale du câble (50)
- appliquer une force de serrage sur la surface latérale du câble (50) en proximité de la face (55)
- percer une cavité axiale dans la face (55) du câble (50)
- Injecter le courant électrique (I) par un objet conducteur (60, 70) inséré dans la cavité axiale.

9. Procédé selon la revendication précédente, dans lequel l'objet conducteur est un outil d'usinage (60) utilisé pour le perçage de la cavité axiale, ou bien un insert conducteur (70) dont la forme épouse celle de la cavité axiale.

10. Procédé selon l'une des revendications 8 à 9 dans lequel le perçage de la cavité axiale est fait par une fraise conique ou étagée (60).

11. Procédé selon l'une des revendications 8 à 10 dans lequel le câble correspond à un câble multiconducteurs (50) et dans lequel la cavité axiale atteint tous les conducteurs du câble.

12. Procédé selon l'une des revendications 8 à 11 dans lequel l'opération de perçage comprend :
- une phase d'avancement dans laquelle les paramètres opérationnels de l'outil sont choisis pour favoriser l'évacuation de copeaux
- une phase de blocage dans laquelle les paramètres opérationnels de l'outil sont choisis de façon à faire gripper l'outil d'usinage dans le perçage.

13. Procédé selon l'une des revendications 8 à 11 dans lequel l'objet conducteur (70) présente un filetage (74) pour le visser dans la cavité axiale, ou bien le procédé comporte la soudure par friction de l'objet conducteur (70) dans la cavité axiale.

14. Procédé selon l'une des revendications 8 à 13 comprenant la mesure d'une différence de tension électrique entre deux contacts (30) posés sur le câble et séparés d'une distance prédéterminée (ℓ) et détermination de la résistance linéique du câble (50).

## Patentansprüche

1. Vorrichtung zur Injektion eines Stroms (I) in ein elektrisches Kabel (50), umfassend eine Klemmvorrichtung (75), die angeordnet ist, das elektrische Kabel (50) zu klemmen und zu halten und einen Druck auf eine Seitenfläche des elektrischen Kabels (50) in der Nähe einer Fläche (55) des Kabels auszuüben, ein Bearbeitungswerkzeug (60), Mittel zum Antrieb und/oder zur Führung des Bearbeitungswerkzeugs (60), die angeordnet sind, eine axiale Vertiefung in die Fläche (55) des Kabels (50) zum Inneren zu bohren, eine elektrische Schaltung (27), die mit einem leitenden Objekt (60, 70) verbunden ist, das zur Injektion des elektrischen Stroms in das Kabel in die axiale Vertiefung eingeführt ist.

2. Vorrichtung nach dem vorhergehenden Anspruch, wobei das leitende Objekt das Bearbeitungswerkzeug (60), das zum Bohren der axialen Vertiefung genutzt wird, oder ein leitender Einsatz (70), dessen Form jene der axialen Vertiefung annimmt, ist.

3. Vorrichtung nach einem der vorhergehenden Ansprüche, wobei das Bearbeitungswerkzeug (60) eine Kegel- oder Stufenfräse ist.

4. Vorrichtung nach einem der vorhergehenden Ansprüche, wobei der Bohrvorgang Folgendes umfasst:
- eine Vortriebsphase, wobei die Betriebsparameter des Werkzeugs so gewählt sind, dass die Abfuhr von Spänen begünstigt wird
- eine Blockierphase, wobei die Betriebsparameter des Werkzeugs so gewählt sind, dass das Bearbeitungswerkzeug in der Bohrung festsitzt.

5. Vorrichtung nach einem der vorhergehenden Ansprüche, wobei das leitende Objekt (70) ein Gewinde (74) aufweist, um es in die axiale Vertiefung zu schrauben, oder die Vorrichtung Mittel umfasst, um das leitende Objekt (70) innerhalb der axialen Vertiefung in Bewegung zu versetzen und es gegen die Wände der axialen Vertiefung zu pressen, um eine Reibung zu erzeugen und das leitende Objekt (70) in die axiale Vertiefung zu schweißen.

6. Vorrichtung nach einem der vorhergehenden Ansprüche, ferner umfassend zwei Kontakte (50), die um einen bekannten Abstand (ℓ) voneinander beabstandet sind, die mit dem Kabel in elektrischem Kontakt stehen, das vom elektrischen Strom durchströmt wird, eine Vorrichtung zur Messung der elektrischen Spannung (35) zwischen den zwei Kontakten (30) und eine Logikschaltung, die angeordnet ist, den längenbezogenen Widerstand des Kabels (50) basierend auf dem Wert des Stroms, der im Kabel strömt, der elektrischen Spannung zwischen den zwei Kontakten (30) und dem bekannten Abstand, der die elektrischen Kontakte (30) trennt, zu bestimmen.

7. Vorrichtung nach dem vorhergehenden Anspruch, ferner umfassend einen Temperatursensor, um die Temperatur des Kabels zu bestimmen, wobei die Logikschaltung angeordnet ist, den längenbezogenen Widerstand basierend auf der Temperatur des Kabels zu korrigieren.

8. Verfahren zur Injektion eines elektrischen Stroms (I) in ein elektrisches Kabel (50), umfassend die folgenden Vorgänge:
- Erhalten einer Fläche (55), die einem Querschnitt des Kabels (50) entspricht
- Anwenden einer Klemmkraft auf die Seitenfläche des Kabels (50) in der Nähe der Fläche (55)
- Bohren einer axialen Vertiefung in die Fläche (55) des Kabels (50)
- Injizieren des elektrischen Stroms (I) durch ein leitendes Objekt (60, 70), das in die axiale Vertiefung eingeführt ist.

9. Verfahren nach dem vorhergehenden Anspruch, wobei das leitende Objekt ein Bearbeitungswerkzeug (60), das zum Bohren der axialen Vertiefung genutzt wird, oder ein leitender Einsatz (70), dessen Form jene der axialen Vertiefung annimmt, ist.

10. Verfahren nach einem der Ansprüche 8 bis 9, wobei das Bohren der axialen Vertiefung durch eine Kegel- oder Stufenfräse (60) erfolgt.

11. Verfahren nach einem der Ansprüche 8 bis 10, wobei das Kabel einem Mehrleiterkabel (50) entspricht, und wobei die axiale Vertiefung alle Leiter des Kabels erreicht.

12. Verfahren nach einem der Ansprüche 8 bis 11, wobei der Bohrvorgang Folgendes umfasst:
- eine Vortriebsphase, wobei die Betriebsparameter des Werkzeugs so gewählt sind, dass die Abfuhr von Spänen begünstigt wird
- eine Blockierphase, wobei die Betriebsparameter des Werkzeugs so gewählt sind, dass das Bearbeitungswerkzeug in der Bohrung festsitzt.

13. Verfahren nach einem der Ansprüche 8 bis 11, wobei das leitende Objekt (70) ein Gewinde (74) aufweist, um es in die axiale Vertiefung zu schrauben, oder das Verfahren das Reibschweißen des leitenden Objekts (70) in die axiale Vertiefung aufweist.

14. Verfahren nach einem der Ansprüche 8 bis 13, umfassend das Messen einer Differenz elektrischer Spannung zwischen zwei Kontakten (30), die auf dem Kabel aufgebracht sind und um einen vorbestimmten Abstand (ℓ) beabstandet sind, und Bestimmen des längenbezogenen Widerstands des Kabels (50).

## Claims

1. Device for injecting a current (I) into an electrical cable (50) comprising a clamping device (75) arranged to clamp and hold the electrical cable (50) and exert a pressure on a lateral surface of the electrical cable (50) in proximity to a face (55) of the cable, a machining tool (60), means for driving and/or guiding the machining tool (60) arranged so as to drill an axial cavity in the face (55) of the cable (50) inwards, an electrical circuit (27) linked to a conductive object (60, 70) inserted into the axial cavity for the injection of the electrical current into the cable.

2. Device according to the preceding claim, wherein the conductive object is the machining tool (60) used to drill the axial cavity, or else a conductive insert (70) whose form fits that of the axial cavity.

3. Device according to one of the preceding claims, wherein the machining tool (60) is a conical or staged milling cutter.

4. Device according to one of the preceding claims, wherein the drilling operation comprises:
- an advancing phase in which the operational parameters of the tool are chosen to promote the evacuation of chips
- a blocking phase in which the operational parameters of the tool are chosen to as to make the machining tool seize in the drilling.

5. Device according to one of the preceding claims, wherein the conductive object (70) has a threading (74) to screw it into the axial cavity, or else the device comprises means for driving movement of the conductive object (70) in the axial cavity and press it against the walls of the axial cavity to generate a friction and weld the conductive object (70) in the axial cavity.

6. Device according to one of the preceding claims, further comprising two contacts (50) separated by a known distance (1) in electrical contact with the cable passed through by the electrical current, a device for measuring the electrical voltage (35) between the two contacts (30) and a logic circuit arranged to determine the resistance per unit length of the cable (50) based on the value of the current circulating in the cable, the electrical voltage between the two contacts (30), and the known distance separating the electrical contacts (30).

7. Device according to the preceding claim, further comprising a temperature sensor for determining the temperature of the cable, the logic circuit being arranged to correct the resistance per unit length based on the temperature of the cable.

8. Method for injecting an electrical current (I) into an electrical cable (50) comprising the operations of:
- obtaining a face (55) corresponding to a cross-section of the cable (50)
- applying a clamping force onto the lateral surface of the cable (50) in proximity to the face (55)
- drilling an axial cavity in the face (55) of the cable (50)
- injecting the electrical current (I) by a conductive object (60, 70) inserted into the axial cavity.

9. Method according to the preceding claim, wherein the conductive object is a machining tool (60) used for the drilling of the axial cavity, or else a conductive insert (70) whose form fits that of the axial cavity.

10. Method according to one of Claims 8 and 9, wherein the drilling of the axial cavity is done by a conical or staged milling cutter (60).

11. Method according to one of Claims 8 to 10, wherein the cable corresponds to a multiconductor cable (50) and wherein the axial cavity reaches all the conductors of the cable.

12. Method according to one of Claims 8 to 11, wherein the drilling operation comprises:
- an advancing phase in which the operational parameters of the tool are chosen to promote the evacuation of chips
- a blocking phase in which the operational parameters of the tool are chosen so as to make the machining tool seize in the drilling.

13. Method according to one of Claims 8 to 11, wherein the conductive object (70) has a threading (74) to screw it into the axial cavity, or else the method comprises the friction welding of the conductive object (70) in the axial cavity.

14. Method according to one of Claims 8 to 13, comprising the measurement of an electrical voltage difference between two contacts (30) placed on the cable and separated by a predetermined distance (*l*) and determination of the resistance per unit length of the cable (50).
